# EUROPEAN PATENT SPECIFICATION

(11) **EP 4 179 287 B1**
(45) Date of publication and mention of the grant of the patent: **27.08.2025**
(21) Application number: 21746193.8
(22) Date of filing: 13.07.2021
(51) Int. Cl.: G01N 1/28, G01N 1/32

(54) **METHOD AND APPARATUS FOR MICROMACHINING A SAMPLE USING A FOCUSED ION BEAM**
VERFAHREN UND VORRICHTUNG ZUR MIKROBEARBEITUNG EINER PROBE MIT EINEM FOKUSSIERTEN IONENSTRAHL
PROCÉDÉ ET APPAREIL DE MICRO-USINAGE D'UN ÉCHANTILLON À L'AIDE D'UN FAISCEAU IONIQUE FOCALISÉ

(30) Priority: 13.07.2020 NL 2026054
(43) Date of publication of application: 17.05.2023
(73) Proprietor: DELMIC IP B.V., 2628 EB Delft (NL)
(72) Inventor: EFFTING, Andries Pieter Johan, 2628 EB DELFT (NL); DEN HOEDT, Sander Vincent, 2628 EB DELFT (NL)
(74) Representative: Peters, Sebastian Martinus
(86) International application number: PCT/NL2021/050441
(87) International publication number: WO 2022/015163

(56) References cited:
- US-A1- 2018 174 798
- US-A1- 2019 108 971
- US-A1- 2019 304 744
- US-A1- 2020 027 692

## Description

### BACKGROUND

### Field of the Invention

The invention relates to a method and an apparatus for micromachining a sample using Focused Ion Beam, and a correlative inspection apparatus for performing said method. In particular, the invention relates to an apparatus and method for micromachining samples by means of a focused ion beam, to produce samples suitable for inspection in a charged particle beam inspection apparatus, for example an electron microscope.

### Description of the Related Art

Focused Ion Beam (FIB) micromachining for Electron Microscopy (EM) samples is a preparation method which allows to machine samples with high precision and without inducing mechanical artefacts, as for example induced by ultra-microtomy. In addition, dual beam systems combining a FIB with a Scanning Electron Microscope (SEM) are known in the art. These dual beam systems allow to use the SEM to image the sample for navigating and positioning the sample in order to machine a position of interest, and for parallel monitoring of the micromachining process by the FIB.

An example of such a system is described in US2020/0027692 A1. It is noted that this document describes a dual beam system combining a FIB and a SEM, and a separate optical microscope or SEM may be used to study the surface of the sample prior to mounting the sample in the dual beam system.

It is noted, that the micromachining of a sample by means of a FIB can be used, for example, for the manufacturing of lamella (thin slices) of the sample, which are typically imaged using a Transmission Electron Microscope (TEM) .

However, when using such a SEM/FIB system for micromachining beam-sensitive samples, such as for example organic material, the sample may be altered and artifacts may be induced by the electron beam of the SEM, which is undesirable, particularly in those cases where the sample is being processed for high resolution inspection in a Transmission Electron Microscope.

For example, the presence of free charge carriers (electrons or possibly holes) may make the sample vulnerable to chemical reactions, such as decomposition due to bond breakage or reactions involving radical or ionized intermediates. Similarly, also the excitation of bound electrons to high energy, weakly bound states as a result of the cascade of energy dissipation reactions after electron beam irradiation, can lead to chemical modification.

Especially organic materials, such as biological material, polymers, and other soft matter, are for this reason hard to image by means of an electron microscope. However, also inorganic materials may be prone to electron-irradiation induced damage. And even for conducting materials, the decomposition of absorbed gas molecules present in the electron microscope vacuum chamber can modify the surface structure such that the imaging quality is negatively affected.

US 2018/0174798 A1 discloses methods, systems and software for related ion beam milling or machining applications.

### SUMMARY OF THE INVENTION

It is an object of the present invention to provide a method for micromachining vulnerable and/or dynamic materials using a FIB, and preferably to provide lamella from a position of interest of the sample in a substantially undamaged state or in a way that minimizes the chance for imaging artefacts or sample modification by non-invasive determination of regions of interest in-situ in an assembly comprising a FIB apparatus.

In addition or alternatively, it is an object of the present invention to provide a method to monitor the sample during micromachining of the sample by means of a FIB.

According to a first aspect, the present invention provides a method for micromachining a sample using an apparatus for micromachining samples, wherein the apparatus comprises an integral combination of:
a sample holder for holding the sample,
a focused ion beam exposure system comprising an assembly for projecting a focused ion beam onto a first position where, in use, the focused ion beam impinges on the sample held by the sample holder, and
a light optical microscope, wherein the light optical microscope is configured for imaging or monitoring the sample on the sample holder,
wherein the method comprises the steps of:
   capturing one or more light microscopy images of the sample held by the sample holder;
   determining a position and physical dimensions of a region of interest in the sample based on the one or more light microscopy images;
   establish from the one or more light microscopy images settings of the sample holder and/or the focused ion beam exposure system for micromachining the sample to bring at least part of the region of interest more closely to the surface of the sample or to produce a lamella which embodies at least part of the region of interest; and
   activate the focused ion beam exposure system in accordance with the settings for micromachining the sample.

The method of the present invention uses an apparatus in which a Focused Ion Beam (FIB) exposure system and a light optical microscope (LM) are integrated, such that a light beam and/or the FIB can interact subsequently and/or simultaneous with a sample on the sample holder. Preferably, the apparatus only comprises the FIB exposure system and the LM. Since the FIB exposure system and the LM are part of an integral combination, their alignment with respect to each other is at least partially based on the design of the apparatus, and if necessary, can be fine-tuned using for example a marker that can be produced or activated by the FIB and that can be identified by the LM. Accordingly, the relative orientation of the FIB and the LM is or can be established and allows to provide a geometric translation between the LM and the FIB exposure system.

The present invention is based on the realization that such an integral system allows for highly accurate determination of regions of interest in the specimen in a non-invasive manner by using the light optical microscope. The integrated LM/FIB apparatus can thus be used to locate an area within the sample where there is a region of interest using only the light optical microscope.

In addition, due to the known spatial relation between the FIB and the LM, the integrated LM/FIB apparatus of the present invention can establish from the one or more light microscopy images or measurements, how and where the FIB can be employed for micromachining the sample to remove material from the surface of the sample in order to reduce a distance between at least part of the region of interest and the surface of the sample or to produce a lamella which embodies at least part of the region of interest, in particular to allow the region of interest to be studied later by an electron microscope. In particular, the apparatus for micromachining of samples is configured to establish from the one or more LM images, one or more settings of the sample holder and/or the FIB exposure system. Such settings may include, but are not limited to: the dimensions of the focus of FIB, the beam current of the FIB, and position coordinates for the sample holder for positioning the sample in order to allow the FIB to be applied at a desired and/or predetermined position on the sample.

In case the current position of the sample does not allow to apply the FIB at the desired and/or predetermined position on the sample, the sample holder can be used to orient and/or position the sample with respect to the FIB such that the first position is arranged on the sample relative to the at least part of the region of interest for the micro-machining of the sample using the FIB. In addition, or alternatively, the trajectory or intended trajectory of the FIB can be adjusted or arranged to the first position on a desired position on the sample. It is noted that the FIB system preferably comprises deflectors for adjusting the trajectory of the FIB. The settings of these deflectors can be set in order to adjust the intended trajectory of the FIB, prior to activating the FIB.

Subsequently, the FIB can be activated to start the micromachining process of the sample.

According to the method of the invention, the determination of the location of a region of interest and navigating and positioning of the sample for machining the sample using the FIB is performed using the light optical microscope that is integrated with the FIB exposure system. The method of the invention allows to identify the location of a region of interest and to navigate and position the sample in the integrated LM/FIB apparatus of the present invention without a prior charged particle beam exposure of said region of interest. Also, during the micromachining of the sample by the FIB, no prior electron beam exposure of said region of interest is required. The present invention thus provides a method for micromachining vulnerable and/or dynamic materials using a FIB, and to remove material from the sample in order to make the layer of material between the surface of the sample and the region of interest at least thin enough to be able to study the region of interest by means of a transmission electron microscope. Preferably, the method of the present invention is configured to expose at least part of the region of interest of the sample at the surface. Accordingly, the method of the invention allows micromachining the sample such that the region of interest remains in a substantially undamaged state or in a way that minimizes the chance for introducing imaging artefacts or sample modifications. By micromachining the sample to reduce the distance between the region of interest of the sample and the surface of the sample, this part of the region of interest is readily available to be studied by an electron microscope.

In an embodiment, the method further comprising the step of: establish from the one or more light microscopy images which part or parts of the sample need to be micro-machined by the focused ion beam exposure system to bring at least part of the region of interest more closely to the surface of the sample or to produce a lamella which embodies at least part of the region of interest. Preferably, the method is configured to establish from the position and physical dimensions of the region of interest as determined using the light optical microscope, and preferably from this information alone, which part or parts of the sample need to be removed by the FIB to reduce a distance between at least part of the region of interest and the surface of the sample or to produce a lamella which embodies at least part of the region of interest. In addition, the method may also be configured to establish the best way the sample should be machined without substantially damaging the region of interest and/or without substantially introducing artefacts and/or modifying the surface structure of the sample.

In an embodiment, the settings comprise a to be machined position on the sample where to arrange the first position, wherein the method further comprises the step of: moving the sample or at least an intended trajectory of the focused ion beam to locate the first position on the to be machined position on the sample accordingly, preferably before activating the focused ion beam exposure system for micromachining the sample. Preferably, the method is configured to provide a geometric translation between the information from the sample as obtained by the light optical microscope which information provides a to be machined position on the sample, and a positioning of the sample by the sample holder with respect to the trajectory of the FIB, such that the FIB, in use, directly impinges on the sample at the to be machined position. Accordingly, the method allows to maneuver the sample in such a way that the sample or a part thereof does substantially not interfere with the trajectory of the FIB.

In an embodiment, the method further comprises the step of: monitoring the locating of the first position on the sample and/or monitoring the micromachining of the sample using the light optical microscope. The light optical microscope according to this embodiment is configured for imaging or monitoring said first position. The method of the present invention allows to ascertain that the sample is properly positioned so that in use the FIB impinges on the to be machined position, and/or to monitor the sample during micromachining of the sample by means of a FIB.

In an embodiment, the method comprises the step of setting the spot size and/or the beam current of the FIB based on the one or more light microscopy measurements. By setting the spot size and/or the beam current of the FIB, the area and volume of material that is machined by the FIB can be selected. Based on the information obtained by the light microscopy measurements, the spot size and/or the beam current can be set to a relatively large value when a distance between the surface of the sample and the region of interest is large and a large amount of sample material has to be removed to at least reduce the distance between the region of interest and the surface. Alternatively, and again based on the information obtained by the light microscopy measurements, the spot size and/or the beam current can be set to a relatively low value when the distance between the surface of the sample and the region of interest is small and a small amount of sample material has to be removed carefully to reduce the distance between the region of interest and the surface, or to expose the region of interest at the surface, preferably without damaging the region of interest.

In an embodiment, the light optical microscope comprises a super resolution microscopy system, including types that use structured illumination, wherein the super resolution microscopy system provides position information of at least part of the region of interest with a resolution of approximately 300 nm or smaller. This allows to more accurately determine the position and physical dimensions of the region of interest in the sample. The use of a super resolution technique is particularly useful for micro-machining the sample for manufacturing one or more lamella suitable to be studied in a Transmission Electron Microscope (TEM). In order to allow an electron beam to at least partially be transmitted through a sample, this sample needs to be very thin, for example having a thickness of approximately 100 nm. The use of super resolution techniques allows the LM/FIB apparatus of the present invention to micro-machine such thin samples which include at least part of the region of interest.

It is noted that a light optical microscope is much more sensitive to deviation in a direction parallel to the optical axis of the light optical microscope than, for instance, an electron microscope. Accordingly, the light optical microscope can be used to determine the position of the sample and/or the region of interest in the sample, at least in a direction parallel to the optical axis with high precision, even if the light optical microscope is not a super resolution microscopy system.

In an embodiment, the light optical microscope comprises a fluorescence light optical microscope, wherein the method further comprises the step of providing structures around the region of interest with first fluorescent labels which can be observed by the light optical microscope. Preferably, the micromachining is monitored by using fluorescence light from said first fluorescent labels. As such, when the fluorescence of the first fluorescent labels as detected with the light optical microscope goes down in intensity, this is a sign that the FIB is approaching the region of interest. Accordingly, micromachining of the sample can be accurately controlled by monitoring changes in the fluorescence intensity of the first fluorescent labels.

In addition or alternatively, in an embodiment, the method comprises the step of providing the region of interest with second fluorescent labels which can be observed by the fluorescence light optical microscope. Preferably, the micromachining is monitored by using fluorescence light from said second fluorescent labels. As long as the fluorescence of the second fluorescent labels as detected with the light optical microscope does not at least substantially go down in intensity, this is a sign that the region of interest is still enclosed in the sample and/or lamella. Accordingly, micromachining of the sample can be accurately controlled by monitoring changes in the fluorescence intensity of the second fluorescent labels.

It is noted that when using both the first and the second fluorescent labels, the second fluorescent labels are preferably different from the first fluorescent labels, so that they are distinguishable in measurements in a fluorescence light microscope. For example, the fluorescence spectrum of the first fluorescent labels differs from the fluorescence spectrum of the second fluorescent labels, preferably in manner that is distinguishable by the fluorescence light optical microscope. Furthermore, the first and/or the second fluorescent labels may comprise a fluorescent protein. Fluorescent proteins are very suitable for labeling regions of interest in biological specimens or samples.

In an embodiment, the method of the invention comprises the step of manufacturing one or more lamella from the sample which includes at least part of the region of interest. In this respect, a lamella is a thin cut-out from a thicker sample, preferably with a thickness suitable for studying the lamella in a TEM. Such a lamella includes the at least part of the region of interest which can later be studied in a TEM. Subsequently, the sample holder and/or the (intended) trajectory of the FIB can be oriented and/or positioned with respect to each other such that the first position is arranged on the sample for the manufacturing of the lamella which includes at least part of the region of interest. Subsequently, the FIB can be activated to start the micromachining process for making the lamella.

In an embodiment, the to be produced lamella is configured to comprise an observation surface, wherein the apparatus for micromachining the sample is configured to orient the sample and the FIB with respect to each other such that the FIB impinges on the sample at an oblique or grazing angle with respect to said observation surface. As indicated above, the lamella with the at least part of the region of interest are intended to be studied in an TEM. Accordingly, the lamella is a very thin section of the sample which is configured to be studied in an electron microscope in transmission. When studied in the electron microscope, the electron beam passes at least partially through an upper and lower surface of the lamella, and the transmitted electron beam is used to provide a transmission image of the lamella. The surfaces through which the electron beam passes are referred to herein as observation surfaces. By arranging the sample and the FIB with respect to each other such that the FIB impinges on the sample at an oblique or grazing angle with respect to said observation surface, it can at least substantially be prevented that ions from the FIB are implanted in the lamella surface. Accordingly, the method according to this embodiment further reduces the chance that the lamella that is provided comprises artefacts due to the micromachining of the sample using the FIB.

In an embodiment, the method further comprises the step of monitoring the creation of the lamella using the light optical microscope, preferably using a super resolution technique, such as the above described fluorescent labeling of the sample. Accordingly, the same light optical microscope that is used to identify the region of interest, is also used to monitor the creation of the lamella. In an embodiment, the method further comprises the step of determining how close the lamella is to containing at least a part of the region of interest and/or determining an angle of approach between the FIB and the region of interest. In an embodiment, the monitoring step of the previous embodiment(s) is used to determine whether at least a part of the region of interest is still enclosed within the lamella. Accordingly, these embodiments of the method of the present invention allow to control the micro-machining in order to obtain a lamella with at least a part of the region of interest.

In an embodiment, the monitoring step of the previous embodiment(s) is used to determine and/or correct a drift of the sample position, at least during the creation of a lamella, in particular at least a drift in a direction parallel to an optical axis of an objective lens of the light optical microscope. In particular when using a high resolution optical objective lens and/or a confocal light microscope arrangement, the light optical microscope is very sensitive to deviations in a direction parallel to the optical axis of the objective lens. Deviations of less than one micrometer can easily be determined. Accordingly, this allows for easy tracking of the focus position.

In an embodiment, the method further comprises the steps of:
evaluating the lamella in a TEM, and
using a result of said evaluation to provide feedback to the apparatus for micromachining a sample to improve the targeting of a region of interest in a subsequent micromachining of a lamella.

Preferably, the lamella is evaluated in a separate TEM, which thus is not integral with the integral FIB/LM apparatus of the present invention. From the TEM or cryo-TEM measurements it can be established whether or not the lamella as produced by the FIB actually contained at least part of the region of interest and/or a protein of interest. Based on the data from the TEM or cryo-TEM the method for manufacturing the lamella in the integrated LM/FIB apparatus can be improved to increase the probability that a next lamella manufactured with this apparatus indeed comprises the desired part of the region of interest and/or the protein of interest.

In an embodiment, the sample holder comprises a cooling system for cooling the sample, wherein the method further comprises the step of cooling the sample prior to the micromachining of the sample by the FIB, preferably cooling the sample down to a cryogenic temperature. In particular for organic or other vulnerable samples which are commonly studied in a cryo-TEM it is advantageous to perform the micromachining on a cooled sample, preferably on a sample which is already cooled down to a cryogenic temperature so that the sample after being micro-machined by the FIB is readily available for investigation in a cryo-TEM.

In an embodiment, the sample is cooled prior to a positioning of the sample in the sample holder. Accordingly, the sample holder does not need to cool the whole sample but only needs to maintain the low temperature of the sample, and the cooling capacity of the cooling system of the sample holder does not need to be very high such that a relatively small cooling system may be sufficient in this case.

In an embodiment, the light optical microscope comprises a focus tracker, wherein the method further comprises the step of focusing the light optical microscope on the sample holder, and/or focusing the light optical microscope on a lamella that is being created by micromachining the sample using the focused ion beam exposure system.

According to a second aspect, the present invention provides an apparatus according to claim 12.

The apparatus of the invention is configured to use the light optical microscope to determine the location of a region of interest and navigating and/or positioning of the sample prior to machining the sample using the focused ion beam (FIB) exposure system. In particular due to the integral combination of the light optical microscope and the FIB exposure system, the apparatus of the invention allows to identify the location of a region of interest and to navigate and position the sample in the integrated LM/FIB apparatus of the present invention without a prior charged particle beam exposure of said region of interest. Preferably, said apparatus is configured for performing the method as described above, or an embodiment thereof.

In an embodiment, the light optical microscope comprises a cylindrical lens, wherein the cylindrical lens is preferably arranged in a light optical path towards a detector of the light optical microscope. In an embodiment, the cylindrical lens is a first cylindrical lens, wherein the light optical microscope comprises a second cylindrical lens which is preferably arranged adjacent to the first cylindrical lens, and wherein a cylinder axis of the second cylindrical lens is arranged at an angle θ with respect to the cylinder axis of the first cylindrical lens, wherein the angle θ is defined in a plane perpendicular to the optical axis of the light optical path towards the detector. Preferably the angle θ is larger than 0 degrees and smaller than 360 degrees. By providing the light optical microscope with a cylindrical lens, In particular in the light optical path towards the detector of the light optical microscope, the resolution in a direction along an optical axis of an objective lens of the light optical microscope can be improved.

In an embodiment, the light optical microscope comprises an optical objective lens having an optical axis, wherein the apparatus comprises a mirror which is arranged on the optical axis at a position spaced apart from the optical objective lens, and wherein the sample holder is configured for holding a sample in between the optical objective lens and the mirror. Preferably, said mirror comprises a flat mirror. By providing the apparatus with a mirror in the orientation as defined above, the resolution in a direction along an optical axis of an objective lens of the light optical microscope can be improved.

In an embodiment, the light optical microscope comprises a focus tracker. Preferably the focus tracker is configured to focus the light optical microscope on the sample holder, and/or on a lamella that is being created by micromachining the sample using the focused ion beam exposure system. In use, the focus tracker keeps the sample in the focus of the light optical microscope. In addition or alternatively, the focus tracker provides information about the position of the sample in a direction along the optical axis of the light optical microscope. This information can be used to control the positioning of the sample by the sample holder before and/or during applying the FIB for micro-machining the sample.

In an embodiment, the light optical microscope is a fluorescence microscope and/or a super resolution light optical microscope. By incorporating a fluorescence microscope and/or a super resolution light optical microscope the resolution of the LM can be improved as described in more detail above.

In an embodiment, the sample holder comprises a cooling system for cooling the sample, preferably wherein the cooling system is configured for cooling the sample down to a cryogenic temperature. This allows to micro-machine the sample under cryogenic conditions.

In an embodiment, the apparatus further comprises:
an electron beam exposure system comprising an assembly for projecting an electron beam towards a position on the sample holder where, in use, the sample held by the sample holder, and
a detector system,
wherein the sample holder is configured to position the sample in between the electron beam exposure system and the detector system, wherein the detector system is configured for detecting electrons transmitted through at least a part of the sample, preferably through a lamella.

Accordingly, the apparatus for micromachining of samples comprising an integral combination of a sample, a focused ion beam exposure system, and a light optical microscope, is further provided with an integral arranged TEM. This TEM allows evaluation of the micro-machined sample, in particular the lamella as produced with the FIB. The result of said evaluation can be used to provide feedback to the apparatus for micromachining a sample to improve the targeting of a region of interest in a subsequent micromachining of a lamella.

In an embodiment, the detector system comprises a sheet of a scintillator material, wherein the sheet of scintillator material is arranged in between a position on the sample holder where, in use, a sample is positioned, and an objective lens of the light optical microscope, wherein the light optical microscope is configured for acquiring an image of at least a part of the sheet of the scintillator material. In an embodiment, the apparatus comprises an actuator for moving the sheet of scintillator material from a first position where the scintillator material is arranged in between the position on the sample holder where, in use, a sample is positioned, and the objective lens of the light optical microscope, to a second position where the scintillator material is removed from the area in between the position on the sample holder where, in use, a sample is positioned, and the objective lens of the light optical microscope, or *vice versa.*

The various aspects and features described and shown in the specification can be applied, individually, wherever possible. These individual aspects, in particular the aspects and features described in the attached dependent claims, can be made subject of divisional patent applications.

### BRIEF DESCRIPTION OF THE DRAWINGS

The invention will be elucidated on the basis of an exemplary embodiment shown in the attached drawings, in which:
Figure 1 schematically shows a first example of an integral LM/FIB apparatus according to the invention,
Figure 2 schematically shows a second example of an integral LM/FIB apparatus according to the invention,
Figures 3 - 8 schematically show subsequent steps for micromachining a sample according to an example of a method according to the invention,
Figure 9 schematically shows a sample in which the material surrounding the region of interest comprises first fluorescent labels,
Figure 10 schematically shows a sample in which the region of interest comprises second fluorescent labels,

### DETAILED DESCRIPTION OF THE INVENTION

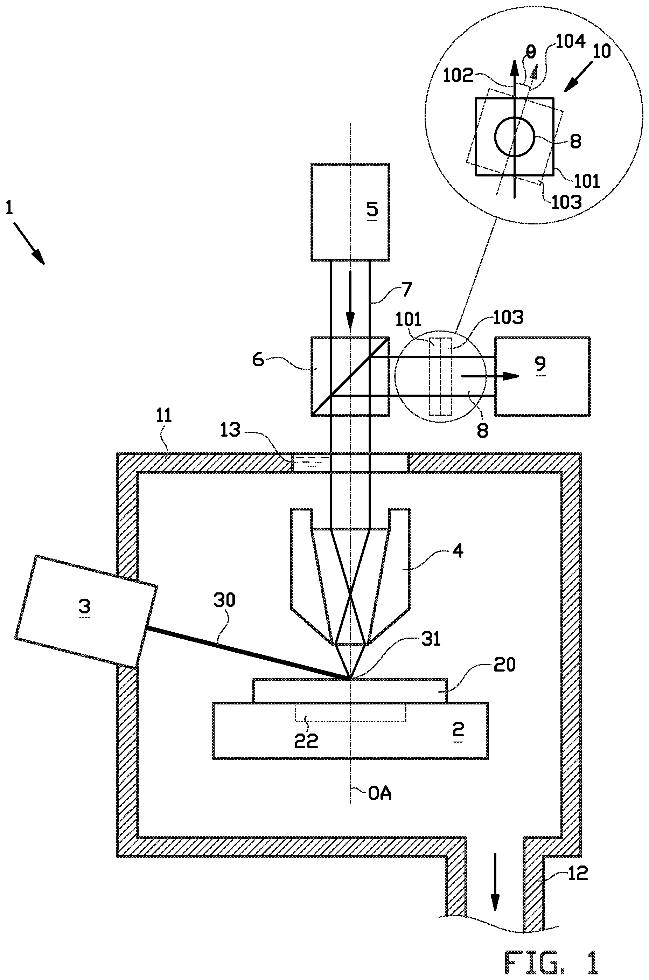

Figure 1 schematically shows a first exemplary embodiment of an apparatus 1 according to the present invention. The apparatus 1 contains an integral combination of a sample holder 2 for holding a sample 20, a focused ion beam exposure system 3, and a light optical microscope.

The light optical microscope comprises an objective lens 4, a light source 5 and a detector 9. The light source 5 is configured to direct light 7 from the light source 5 towards the objective lens 4, which is configured to focus the light onto the sample 20 on the sample holder 2. In the beam path in between the light source 5 and the objective lens 4, a half transparent mirror or dichroic mirror 6 is arranged, which is configured to pass at least part of the light 7 from the light source 5 towards the objective lens 4 to illuminate the sample 20.

The objective lens 4 is furthermore configured to collect light coming from the sample 20. The light collected by the objective lens 4 is at least partially reflected by the half transparent mirror or dichroic mirror 6 to direct said collected light 8 towards the detector 9.

Accordingly, the light optical microscope is configured to observe the sample 20 on the sample holder 2, taking optical measurement and/or optical images from the sample 20.
preferably, the light source 5 is configured to emit light within a certain first wavelength or first wavelength range configured for exciting particular fluorescent labels and/or fluorescent molecules in the sample 20. In addition or alternatively, the detector 9 is configured for detecting light within a certain second wavelength or second wavelength range for detecting particular fluorescent labels and/or fluorescent molecules in the sample 20. The first wavelength or first wavelength range may be different from the second wavelength or second wavelength range.

As schematically shown in figure 1, the focused ion beam exposure system 3 is configured to project a focused ion beam 30 onto the surface of the sample 20 on the sample holder 2. Preferably, the beam spot size and/or the beam current of the focused ion beam 30 are configured so that the focused ion beam 30 can remove material from the surface of the sample 20, and thus can micro-machine the sample 20.

The focused ion beam exposure system 3 is typically arranged inside a vacuum chamber 11 which is connected to a vacuum pump via a connector 12.

As schematically shown in figure 1, the sample holder 2 and the microscope objective 4 are also arranged inside the vacuum chamber 11. Also the other parts of the light optical microscope may be arranged inside the vacuum chamber 11, but preferably at least the light source 5 and the detector 9 are arranged in an illumination and detection part, outside the vacuum chamber 11. The vacuum chamber 11 is provided with an optical window 13 which is arranged in the light beam path between the half transparent mirror or dichroic mirror 6 and the microscope objective 4. Due to the illumination and detection part outside the vacuum chamber 11, the light source and the detector 9 do not have to be vacuum-proof.

Because of the integral combination of the light optical microscope and the focused ion beam exposure system 3, the optical axis OA of the light optical microscope and the focused ion beam 30 axis are at least partially linked by design. This relation between the optical axis OA of the light optical microscope and the focused ion beam 30 allows to establish from the one or more light microscopy measurements or images where (position) and how (spatial orientation) to position the sample 20 in order to machine the desired part(s) of the sample 20 with the Focused ion beam 30.

It is noted that the focused ion beam exposure system 3 is configured for projecting the focused ion beam 30 onto a first position 31. The sample 20 is positioned by the sample holder 2 so that the first position 31 at least substantially coincides with a position on the sample 20 which needs to be treated by the focused ion beam 30. Preferably, the first position 31 is arranged so that it can be imaged or monitored by the light optical microscope. In the example as shown in figure 1, the first position is arranged at or near the optical axis OA of the light optical microscope.

It is noted, that the apparatus 1 preferably comprises a controller (not shown) which is connected to the light optical microscope, at least the detector 9 thereof, the focused ion beam exposure system 3, and the sample holder 2. The controller is configured for controlling the apparatus 1 to perform, in use, the steps of the method or an embodiment thereof as described below.

In use, light 7 from the light source 5 is directed towards the objective lens 4, which is configured to illuminate the sample 20. Light 8 from the sample is collected by the objective lens 4 and directed to the detector 9. In particular, the objective lens 4 is furthermore configured to collect light coming from the sample 20. The light collected by the objective lens 4 is at least partially reflected by the half transparent mirror or dichroic mirror 6 to direct said collected light 8 towards the detector 9. Preferably, the light optical microscope is configured to project an image of the sample surface onto the detector 9, wherein the detector 9 comprises a camera, for example a CCD camera, in order to capturing one or more light microscopy images of the sample 20 held by the sample holder 2.

Using the one or more light microscopy images as captured by the detector 9, a position and physical dimensions of a region of interest in the sample 20 can be determined. This determination can be performed by a user, for example by displaying said one or more light microscopy images on a display screen, wherein the user may select a part or a position in said one or more light microscopy images as a regions of interest. In addition or alternatively, this determination may be performed by a computing device or image analyzer, preferably using a predetermined contrast feature which enables the computing device or image analyzer to distinguish between the region of interest from the surrounding sample material.

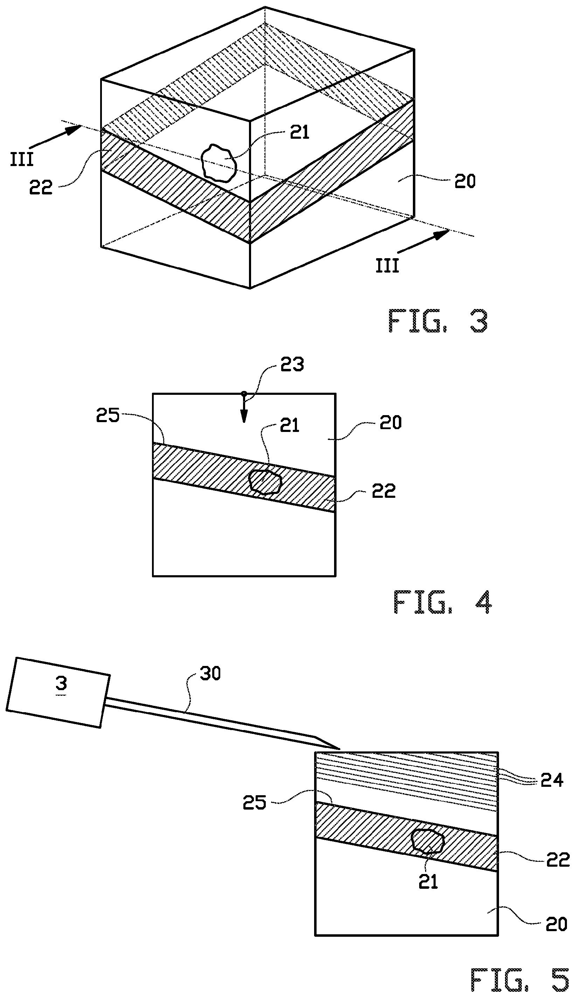

Subsequently, the user and/or the computing device or image analyzer establishes from the one or more light microscopy images settings of the sample holder and/or the focused ion beam exposure system for micromachining the sample 20 to remove material form the surface of the sample 20 in order to reduce a distance between at least part of the region of interest and the surface of the sample 20 or to produce a lamella which embodies at least part of the region of interest, as will be explained in more detail below with reference to figures 3 to 8.

Optionally, the light optical microscope is provided with a cylinder lens arrangement 10 arranged in the light optical path 8 towards the detector 9 of the light optical microscope, to improve the resolution of the light optical microscope along the optical axis OA. The cylinder lens arrangement 10 comprises a first cylindrical lens 101 and a second cylindrical lens 103 which is preferably arranged adjacent to the first cylindrical lens 101 in a direction parallel to the light optical path 8.The first cylindrical lens 101 comprises a cylinder axis 102 and the second cylindrical lens 103 comprises a cylinder axis 104. As schematically shown in the front view detail in figure 1, the cylinder axis 104 of the second cylindrical lens 103 is arranged at an angle θ with respect to the cylinder axis 102 of the first cylindrical lens 101. The angle θ is defined in a plane perpendicular to the optical axis of the light optical path 8 towards the detector 9. Preferably, the angle θ is larger than 0 degrees and smaller than 360 degrees. Preferably the angle θ is adjustable.

Optionally, the sample holder 2 is provided with a mirror 22 which is arranged on the optical axis OA at a position spaced apart from the optical objective lens 4, and wherein the sample holder 2 is configured for holding a sample 20 in between the optical objective lens 4 and the mirror 22. Preferably, said mirror 22 comprises a flat mirror. By providing the apparatus with a mirror 22 in the orientation as shown in figure 1, the resolution in a direction along the optical axis OA of an objective lens 4 of the light optical microscope can be improved.

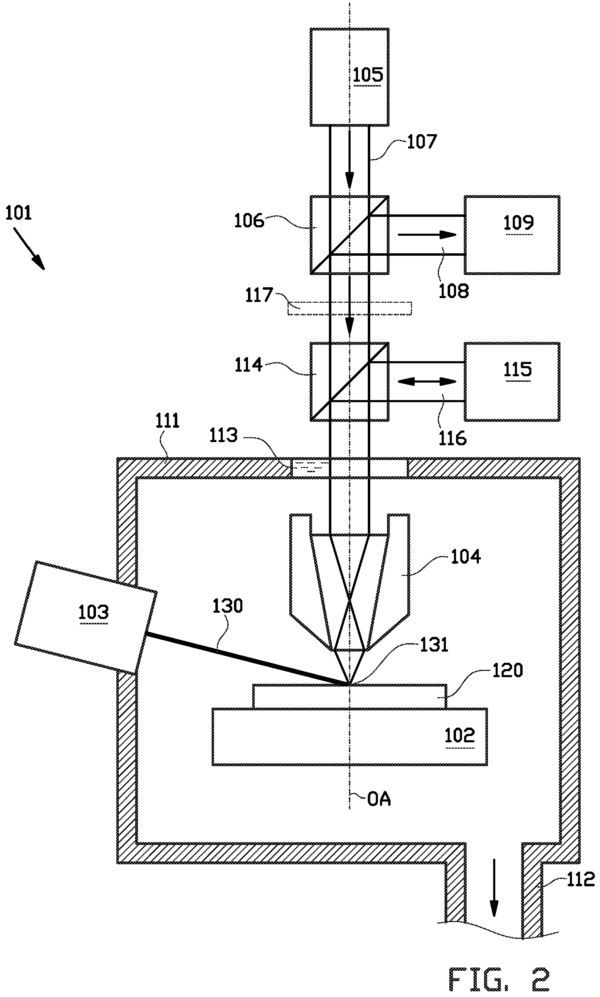

Figure 2 schematically shows a second exemplary embodiment of an apparatus 101 according to the present invention. The apparatus 101 contains an integral combination of a sample holder 102 for holding a sample 120, a focused ion beam exposure system 103, and a light optical microscope.

Again, the light optical microscope comprises an objective lens 104, a light source 105 and a detector 109, in a same configuration as in the first exemplary embodiment as described above with reference to figure 1. Accordingly, the light optical microscope is configured to observe the sample 120 on the sample holder 102, taking optical measurement and/or optical images from the sample 120.

As schematically shown in figure 2, the light optical microscope comprises a second dichroic mirror 114 and a focus tracker 115. The dichroic mirror 114 is configured to reflect Infra-red light and to transmit visible light. Accordingly, Infra-red light 116 from the focus tracker 115 is reflected by the dichroic mirror 114 into the optical path of the light optical microscope and is projected onto the sample 120 by the objective lens 104. The reflected Infra-red light is picked up by the objective lens 104 and is directed along the optical path of the light optical microscope up to the dichroic mirror 114, which again reflects said Infra-red light and projects the Infra-red light 116 to the focus tracker 115. The focus tracker 115 is configured to determine whether or not the sample 120 is arranged in the focus position of the light optical microscope. When the sample 120 is not in the focus position of the light optical microscope, the focus tracker 115 can provide a signal to the sample holder 102 or a controller which controls the sample holder 102, in order to enable an adjustment of relative position of the sample 120 with respect to the objective lens 104.

Optionally, the light optical microscope comprises a blocking filter 117 which is configured for at least substantially blocking the Infra-red light used by the focus tracker 115. The blocking filter 117 can at least substantially prevent that the Infra-red light used by the focus tracker 115, interferes with the light optical measurements by the light optical microscope.

As schematically shown in figure 2, the focused ion beam exposure system 103 is configured to project a focused ion beam 130 onto the surface of the sample 120 on the sample holder 102. Preferably, the beam spot size and/or the beam current of the focused ion beam 130 are configured so that the focused ion beam 130 can remove material from the surface of the sample 120, and thus can micro-machine the sample 120.

The focused ion beam exposure system 103 is typically arranged inside a vacuum chamber 111 which is connected to a vacuum pump via a connector 112.

As schematically shown in figure 2, the sample holder 102 and the microscope objective 104 are also arranged inside the vacuum chamber 111. Also the other parts of the light optical microscope may be arranged inside the vacuum chamber 111, but preferably at least the light source 105, the detector 109, and the focus tracker 115 are arranged in an illumination and detection part, outside the vacuum chamber 111. The vacuum chamber 111 is provided with an optical window 113 which is arranged in the light beam path between the dichroic mirror 114 and the microscope objective 104.

Because of the integral combination of the light optical microscope and the focused ion beam exposure system 103, the optical axis OA of the light optical microscope and the focused ion beam 130 axis are at least partially linked by design. This relation between the optical axis OA of the light optical microscope and the focused ion beam 130 allows to establish from the one or more light microscopy measurements or images where (position) and how (spatial orientation) to position the sample 120 in order to machine the desired part(s) of the sample 120 with the Focused ion beam 130.

Just as in the previous example, the focused ion beam exposure system 103 is configured for projecting the focused ion beam 130 onto a first position 131. The sample 120 is positioned by the sample holder 102 so that the first position 131 at least substantially coincides with a position on the sample 120 which needs to be treated by the focused ion beam 130. Preferably, the first position 131 is arranged so that it can be imaged or monitored by the light optical microscope. In the example as shown in figure 2, the first position is arranged at or near the optical axis OA of the light optical microscope.

In use, light 107 from the light source 105 is directed towards the objective lens 104, which is configured to illuminate the sample 120. The objective lens 104 is furthermore configured to collect light coming from the sample 120. The light collected by the objective lens 104 is at least partially reflected by the half transparent mirror or dichroic mirror 106 to direct said collected light 108 towards the detector 109. In particular, the light optical microscope is configured to project an image of the sample surface onto the detector 109, wherein the detector 109 comprises a camera, for example a CCD camera, in order to capturing one or more light microscopy images of the sample 120 held by the sample holder 102. The focus tracker 115 can be used to position and hold the sample 120 on the sample holder 102 in focus, before or during the imaging.

Using the one or more light microscopy images as captured by the detector 109, a position and physical dimensions of a region of interest in the sample 120 can be determined. This determination can be performed by a user, for example by displaying said one or more light microscopy images on a display screen, wherein the user may select a part or a position in said one or more light microscopy images as a regions of interest. In addition or alternatively, this determination may be performed by a computing device or image analyzer, preferably using a predetermined contrast feature which enables the computing device or image analyzer to distinguish between the region of interest from the surrounding sample material.

Subsequently, the user and/or the computing device or image analyzer establishes from the one or more light microscopy images settings of the sample holder and/or the focused ion beam exposure system for micromachining the sample 120 to remove material form the surface of the sample 120 in order to reduce a distance between at least part of the region of interest and the surface of the sample 120 or to produce a lamella which embodies at least part of the region of interest, as will be explained in more detail below with reference to figures 3 to 8.

Figure 3 schematically shows an example of a sample 20 which comprises a region of interest 21 as identified by a used and/or by a computing device or image analyzer. Figure 4 schematically shows a cross-section along the line III - III of figure 3. As indicated, the region of interest 21 in this example is arranged inside the sample 20. At this position, the region of interest 21 cannot be studied using an electron microscope because of the limited penetration depth of electrons into the sample 20.

From the one or more light microscopy images as obtained by the light optical microscope from the sample 20, the position of the region of interest 21 in the sample 20 can be established.

In addition, from the information from these light microscopy images, and preferably from this information alone, a preferred way to machine the sample 20 can be established in order to bring at least part of the region of interest 21 more closely to the surface of the sample 20 or to produce a lamella 22 which embodies at least part of the region of interest 21. In order to establish the preferred way to machine the sample 20, the apparatus of the present invention or a controller thereof is preferably configured to also take account of the topography of the surface(s) of the sample 20 and/or the relative orientation of the sample on the sample holder 2 with respect to the focused ion beam exposure system 3, in particular with respect to the focused ion beam 30 and/or the position of the focus of the focused ion beam 30, which focus is preferably arranged at or near said first position.

Furthermore, the apparatus of the invention or a controller thereof is preferably configured to arrange the sample 20 and the focused ion beam 30 with respect to each other such that the focused ion beam 30 impinges on the sample 20 at an oblique or grazing angle with respect to an intended observation surface 25, 25', in order to at least substantially prevent that ions from the focused ion beam are implanted in said observation surface 25, 25'.

When the position of the region of interest 21 and a position and/or orientation of an intended observation surface 25 has been established, a preferred way to machine the sample 20 to remove the material 23 of the sample which is arranged at a side of the intended observation surface 25 facing away from the region of interest 21, is established as schematically shown in figure 4.

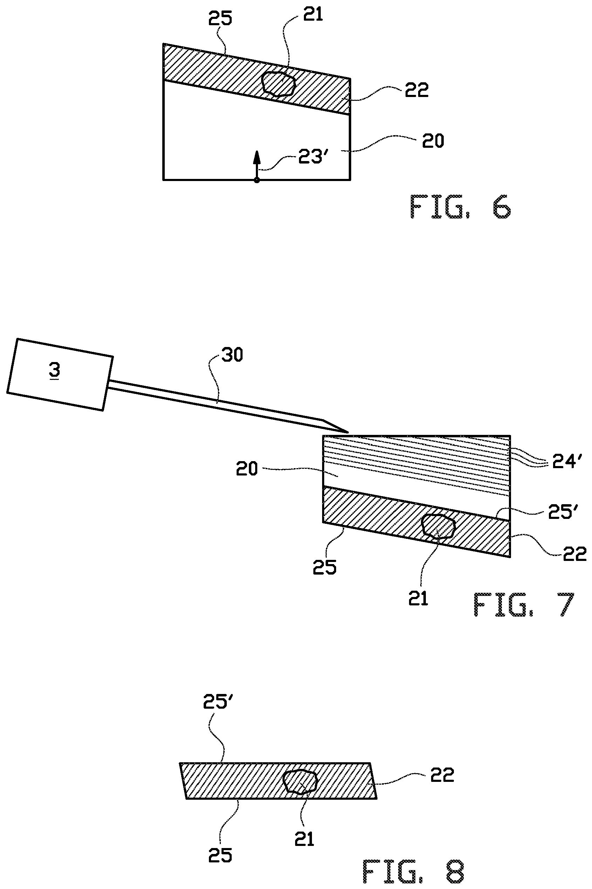

Subsequently, the sample holder 2 is controlled to position the sample 20 with respect to the focused ion beam 30 such that the material 23 of the sample which is arranged at a side of the intended observation surface 25 facing away from the region of interest 21 can be removed as schematically shown in figure 5. As also schematically shown in figure 5, the focused ion beam 30 impinges on the sample 20 at an oblique or grazing angle with respect to an intended observation surface 25. The sample holder and/or the focused ion beam exposure system are configured to remove said material 23 layer by layer 24 in order to expose the intended observation surface 25 and make the intended observation surface 25 the new surface of the sample, as schematically shown in figure 6.

The sample 20 as shown in figure 6, where the region of interest 21 is at or just below the observation surface 25, can be used to study the sample in a Scanning Electron Microscope (SEM).

However, in order to study the region of interest 21 in great detail, the use of a Transmission Electron Microscope (TEM) is commonly preferred. In order to make the sample 20 suitable for studying the region of interest 21 with a TEM, the sample 20 must be further machined in order to obtain a lamella 22. Such a lamella uses the observation surface 25 as a first observation surface. In order to from a thin lamella 2, an intended second observation surface needs to be defined, which second observation surface is at least substantially parallel to the first observation surface, and preferably in such a way that at least part of the region of interest 21 is arranged in between the first and second observation surface. The intended second observation surface 25' can be obtained by removing the material 23' of the sample 20 which is arranged at a side of an intended second observation surface 25' facing away from the region of interest 21, as schematically shown in figure 6.

Accordingly, the sample holder 2 is controlled to position the sample 20 with respect to the focused ion beam 30 such that the material 23' of the sample 20 which is arranged at a side of the intended second observation surface 25' facing away from the region of interest 21 can be removed, preferably layer by layer 24', as schematically shown in figure 7.

It is noted, that instead of first machining the sample at the first side to expose the intended first observation surface and subsequently machining the sample at the second side to expose the intended second observation surface, the method of the present invention may also comprise the steps of:
- removing a thin layer of material from the first and second side of the sample by the focused ion beam exposure system;
- optionally capturing one or more light microscopy images of the sample held by the sample holder, determining anew a position and physical dimensions of a region of interest in the sample based on the one or more light microscopy images, and establish from the one or more light microscopy images settings of the sample holder and/or the focused ion beam exposure system for micromachining the sample to bring at least part of the region of interest more closely to the surface of the sample or to produce a lamella which embodies at least part of the region of interest, and
- activate the focused ion beam exposure system in accordance with the settings for micromachining the sample and removing a further thin layer of material from the first and second side of the sample in order to bring the surfaces of the sample more close to the region of interest,
- optionally, repeating the above steps until the desired thickness of the lamella has been reached.

The result of the micro-machining is a lamella 22 as schematically shown in figure 8, which represent a thin lamella 22 with a first observation surface 25 and a second observation surface 25', and at least part of the region of interest 21 in between said first and second observation surfaces, with a thickness suitable for studying the lamella 22 in transmission by a TEM.

As schematically shown in figure 1, the position 31 where the focused ion beam 30 is focused on the sample 20 can be observed by the light optical microscope. Such observation may be carried out using the light optical contrast as provided by the illumination of the sample 20 by the light source 5.

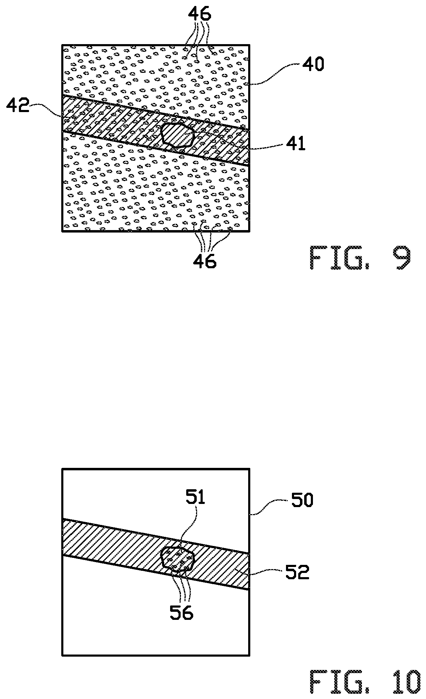

However, the sensitivity of observing a progress of the removal of material from the sample 40 can be increased by providing the material around the region of interest 41 with first fluorescent labels 46 which can be observed by the light optical microscope, as schematically shown in figure 9. Accordingly, the micromachining of the sample 40 can be monitored by using fluorescence light from said first fluorescent labels 46. As such, when the fluorescence of the first fluorescent labels 46 as detected with the light optical microscope goes down in intensity, this is a sign that the focused ion beam is approaching the region of interest 41. Accordingly, micromachining of the sample 40, preferably for manufacturing a lamella 42 comprising the region of interest 41, can be accurately controlled by monitoring changes in the fluorescence intensity of the first fluorescent labels 46. For this, the light source is configured to illuminate the sample 40 with light of a wavelength suitable for excitation of the first fluorescent labels 46, and the detector is configured to detect the light emitted by the first fluorescent labels 46, preferably in a selective manner.

In addition or alternatively, the region of interest 51 can be provided with second fluorescent labels 56 as schematically shown in figure 10. Observing the fluorescence light from said second fluorescent labels 56, and in particular changed is the intensity of said fluorescence light, allows to monitor whether or not the region of interest 51 is being micromachined. As long as the fluorescence of the second fluorescent labels 56 as detected with the light optical microscope does not at least substantially go down in intensity, this is a sign that the region of interest 51 is still enclosed in the sample 50 and/or lamella 52. Accordingly, micromachining of the sample 50, preferably for manufacturing a lamella 52 comprising the region of interest 51, can be accurately controlled by monitoring changes in the fluorescence intensity of the second fluorescent labels 56. For this, the light source is configured to illuminate the sample 50 with light of a wavelength suitable for excitation of the second fluorescent labels 56, and the detector is configured to detect the light emitted by the second fluorescent labels 56, preferably in a selective manner.

It is noted, that the interaction between the focused ion beam 30 and the sample material may result in an emission of secondary electrons. These secondary electrons may travel over tens of nanometers from the first position where the focused ion beam 30 impinges on the sample, which secondary electrons may then interact with any fluorescent labels 56 present, to induce changes in the fluorescence intensity. Accordingly, when using fluorescent labels 56 which interact with secondary electrons, a change in fluorescence intensity can be observed while the focused ion beam 30 is still tens of nanometers away from the region of interest 56, which may be used to further safeguard that the region of interest 56 is not machined by the focused ion beam 30.

It is further noted, that in case the sample is provided with both the first fluorescent labels 46 and the second fluorescent labels 56, it is preferable that the first fluorescent labels 46 are different from the second fluorescent labels 56, preferable such that the fluorescent light from the first fluorescent labels 46 has a different wavelength or wavelength range in comparison to the fluorescent light from the second fluorescent labels 56, and that the detector is configured to be able to distinguish between the fluorescent light from the first fluorescent labels 46 and the fluorescent light from the second fluorescent labels 56.

It is to be understood that the above description is included to illustrate the operation of the preferred embodiments and is not meant to limit the scope of the invention. From the above discussion, many variations will be apparent to one skilled in the art that would yet be encompassed by the scope of the present invention.

In summary, the invention relates to an apparatus and a method for micromachining samples. The apparatus comprises an integral combination of: a sample holder, a focused ion beam (FIB) exposure system for projecting a FIB onto a first position on the sample, and a light optical microscope (LM), wherein the LM is configured for imaging or monitoring said first position. The method comprises the steps of:
- capturing LM images of the sample;
- determining a position and physical dimensions of a region of interest in the sample based on the LM images;
- establish from the LM images settings of the sample holder and/or the FIB exposure system, for micromachining the sample to bring the region of interest more closer to the surface, and move the sample or the trajectory of the FIB to locate the first position on the sample accordingly, and
- activate the FIB for micromachining the sample.

## Claims

1. A method for micromachining a sample using an apparatus (1, 101) for micromachining of samples (20, 120), wherein the apparatus (1, 101) comprises an integral combination of:
a sample holder (2, 102) for holding the sample (20, 120),
a focused ion beam exposure system comprising an assembly for projecting a focused ion beam (30, 130) onto a first position (31, 131) where, in use, the focused ion beam (30, 130) impinges on the sample (20, 120) held by the sample holder (2, 102), and
a light optical microscope, wherein the light optical microscope is configured for imaging or monitoring the sample (20, 120) on the sample holder (2, 102),
wherein the method comprises the step of capturing one or more light microscopy images of the sample (20, 120) held by the sample holder (2, 102) and is **characterized by** the further steps of:
determining a position and physical dimensions of a region of interest (21, 41, 51) in the sample (20, 120) based on the one or more light microscopy images;
establish from the one or more light microscopy images settings of the sample holder (2, 102) and/or the focused ion beam exposure system for micromachining the sample (20, 120) to reduce a distance between at least part of the region of interest (21, 41, 51) and the surface of the sample (20, 120) or to produce a lamella (22, 42, 52) which embodies at least part of the region of interest (21, 41, 51); and
activate the focused ion beam exposure system in accordance with the settings for micromachining the sample (20, 120).

2. The method according to claim 1, further comprising the step of:
establish from the one or more light microscopy images which part or parts of the sample (20, 120) need to be micro-machined by the focused ion beam exposure system to reduce the distance between at least part of the region of interest (21, 41, 51) and the surface of the sample (20, 120) or to produce a lamella (22, 42, 52) which embodies at least part of the region of interest (21, 41, 52).

3. The method according to claim 1 or 2, wherein the settings comprises a position on the sample (20, 120) where to arrange the first position (31, 131), wherein the method further comprises the step of:
moving the sample (20, 120) or at least an intended trajectory of the focused ion beam (30, 130) to locate the first position (31, 131) on the position on the sample (20, 120) accordingly, preferably before activating the focused ion beam exposure system for micromachining the sample (20, 120),
preferably further comprising the step of:
monitoring the locating of the first position (31, 131) on the sample (20, 120) and/or monitoring the micromachining of the sample (20, 120) using the light optical microscope.

4. The method according to any one of the claims 1 - 3, wherein the settings comprises a spot size of the focused ion beam (30, 130) at the first position (31, 131) and/or a beam current of the focused ion beam (30, 130).

5. The method according to any one of the claims 1 - 4, wherein the light optical microscope comprises a super resolution microscopy system, including types that use structured illumination, wherein the super resolution microscopy system provides position information of at least part of the region of interest (21, 41, 51) with a resolution of approximately 300 nm or smaller.

6. The method according to any one of the claims 1 - 5, wherein the method further comprises the step of:
providing structures around the region of interest (21, 41, 51) with first fluorescent labels (46) which can be observed by the light optical microscope,
preferably, wherein the method further comprises the step of:
monitoring the micromachining by observing fluorescence light from said first fluorescent labels (46) using the light optical microscope.

7. The method according to any one of the claims 1 - 6, wherein the method further comprises the step of:
providing the region of interest (21, 41, 51) with second fluorescent labels (56) which can be observed by the light optical microscope,
preferably, wherein the method further comprises the step of:
monitoring the micromachining by observing fluorescence light from said second fluorescent labels (56) using the light optical microscope.

8. The method according to any one of the claims 1 - 7, wherein the method further comprises the step of:
manufacturing of one or more lamella (22, 42, 52) from the sample (20, 120) which includes at least part of the region of interest (21, 41, 51), wherein said lamella (22, 42, 52) is a thin cut out for a thicker sample, preferably with a thickness suitable for studying the lamella (22, 42, 52) in a TEM,
preferably, wherein the to be produced lamella (22, 42, 52) is configured to comprise an observation surface (25, 25'), wherein method comprises the step of:
orienting the sample (20, 120) and the FIB with respect to each other such that the FIB impinges on the sample (20, 120) at an oblique or grazing angle with respect to said observation surface (25, 25').

9. The method according to claim 8, wherein the method further comprises the step of:
monitoring the creation of the lamella (22, 42, 52) using the light optical microscope,
preferably, wherein the monitoring step further comprises one or more of the following:
determining how close the lamella (22, 42, 52) is to containing at least a part of the region of interest (21, 41, 51),
determining an angle of approach between the FIB (30, 130) and the region of interest (21, 41, 51),
determining whether at least a part of the region of interest (21, 41, 51) is still enclosed within the lamella (22, 42, 52),
determining and/or correcting a drift of the sample (20, 120) position, in particular at least a drift in a direction parallel to an optical axis (OA) of an objective lens (4, 104) of the light optical microscope.

10. The method according to claim 8 or 9, wherein the method further comprises the step of:
evaluating the lamella (22, 42, 52) in a TEM, and
using a result of said evaluation to provide feedback to the apparatus for micromachining a sample (20, 120) to improve the targeting of a region of interest (21, 41, 51) in a subsequent micromachining of a lamella (22, 42, 52).

11. The method according to any one of the claims 1 - 10, wherein the sample holder (2, 102) comprises a cooling system for cooling the sample (20, 120), wherein the method further comprises the step of:
cooling the sample (20, 120) prior to the micromachining of the sample by the FIB (30, 130), preferably cooling the sample (20, 120) down to a cryogenic temperature.

12. An apparatus (1, 101) for micromachining of samples (20, 120), wherein the apparatus (1, 101) comprises an integral combination of:
a sample holder (2, 102) for holding a sample (20, 120),
a focused ion beam exposure system comprising an assembly for projecting a focused ion beam (30, 130) onto a first position (31, 131) where, in use, the focused ion beam (30, 130) impinges on the sample (20, 120) held by the sample holder (2, 102),
a light optical microscope, wherein the light optical microscope is configured for imaging or monitoring said first position (31, 131), wherein the apparatus (1, 101) further comprises a controller which is configured for controlling the apparatus to perform, in use, the steps of the method according to any one of the claims 1 - 11.

13. The apparatus according to claim 12, wherein the light optical microscope comprises:
a cylindrical lens (101, 102), and/or
an optical objective lens (4) having an optical axis (OA), wherein the apparatus (1, 101) comprises a mirror (22) which is arranged on the optical axis (OA) at a position spaced apart from the optical objective lens (4), and wherein the sample holder (2, 102) is configured for holding a sample (20, 120) in between the optical objective lens (4) and the mirror (22), and/or
a focus tracker (115), preferably wherein the focus tracker (115) is configured to focus the light optical microscope on the sample (20, 120) and/or on a lamella (22, 42, 52) that is being created by micromachining the sample (20, 120) using the focused ion beam exposure system.

14. The apparatus according to claim 12 or 13, wherein the sample holder (2, 102) comprises a cooling system for cooling the sample (20, 120), preferably wherein the cooling system is configured for cooling the sample (20, 120) down to a cryogenic temperature.

15. The apparatus according to any one of the claims 12 - 14, wherein the apparatus (1, 101) further comprises:
an electron beam exposure system comprising an assembly for projecting an electron beam towards a position on the sample holder (2, 102) where, in use, the sample (20, 120) held by the sample holder (2, 102), and
a detector system,
wherein the sample holder (2, 102) is configured to position the sample (20, 120) in between the electron beam exposure system and the detector system, wherein the detector system is configured for detecting electrons transmitted through at least a part of the sample (20, 120), preferably through a lamella (22, 42, 52),
preferably, wherein the detector system comprises a sheet of a scintillator material, wherein the sheet of scintillator material is arranged in between a position on the sample holder (2, 102) where, in use, a sample (20, 120) is positioned, and an objective lens (4, 104) of the light optical microscope, wherein the light optical microscope is configured for acquiring an image of at least a part of the sheet of the scintillator material,
preferably, wherein the apparatus (1, 101) comprises an actuator for moving the sheet of scintillator material from a first position (31, 131) where the scintillator material is arranged in between the position on the sample holder (2, 102) where, in use, a sample (20, 120) is positioned, and the objective lens (4, 104) of the light optical microscope, to a second position where the scintillator material is removed from the area in between the position on the sample holder (2, 102) where, in use, a sample (20, 120) is positioned, and the objective lens (4, 104) of the light optical microscope, or *vice versa.*

## Patentansprüche

1. Verfahren zur Mikrobearbeitung einer Probe unter Verwendung einer Vorrichtung (1, 101) zur Mikrobearbeitung von Proben (20, 120), wobei die Vorrichtung (1, 101) folgende integrale Kombination umfasst:
einen Probenhalter (2, 102) zum Halten der Probe (20, 120),
ein System zur Exposition mit einem fokussierten Ionenstrahl, das eine Anordnung zum Projizieren eines fokussierten Ionenstrahls (30, 130) auf eine erste Position (31, 131) umfasst, in der der fokussierte Ionenstrahl (30, 130) bei der Anwendung auf die Probe (20, 120), die von dem Probenhalter (2, 102) gehalten wird, auftrifft, und
ein optisches Lichtmikroskop, wobei das optische Lichtmikroskop zum Darstellen oder Überwachen der Probe (20, 120) in dem Probenhalter (2, 102) ausgestaltet ist,
wobei das Verfahren den Schritt umfasst: Aufnehmen eines oder mehrerer lichtmikroskopischer Bilder der Probe (20, 120), die von dem Probenhalter (2, 102) gehalten wird;
**gekennzeichnet durch** die weiteren Schritte:
Bestimmen einer Position und der physikalischen Abmessungen einer Region von Interesse (21, 41, 51) in der Probe (20, 120), auf der Grundlage eines oder mehrerer der lichtmikroskopischen Bilder;
Einrichten der Einstellungen des Probenhalters (2, 102) und/oder des Systems zur Exposition mit dem fokussierten Ionenstrahl zur Mikrobearbeitung der Probe (20, 120), aufgrund des einen oder der mehreren lichtmikroskopischen Bilder, um einen Abstand zwischen dem mindestens einen Teil des Bereichs von Interesse (21, 41, 51) und der Oberfläche der Probe (20, 120) zu verringern, oder um eine Lamelle (22, 42, 52), die zumindest einen Teil des Bereichs von Interesse (21, 41, 51) einschließt, zu erzeugen; und
Aktivieren des Systems zur Exposition mit einem fokussierten Ionenstrahl entsprechend der Einstellungen für die Mikrobearbeitung der Probe (20, 120).

2. Verfahren nach Anspruch 1, das außerdem den folgenden Schritt umfasst:
Festlegen, aufgrund des einen oder der mehreren lichtmikroskopischen Bilder, welcher Teil oder welche Teile der Probe (20, 120) durch das System zur Exposition mit dem fokussierten Ionenstrahl mikrobearbeitet werden müssen, um den Abstand zwischen dem wenigstens einen Teil des Bereichs von Interesse (21, 41, 51) und der Oberfläche der Probe (20, 120) zu verringern, oder um eine Lamelle (22, 42, 52) zu erstellen, die wenigstens einen Teil des Bereichs von Interesse (21, 41, 52) verkörpert.

3. Verfahren nach Anspruch 1 oder 2, wobei die Einstellungen eine Position auf der Probe (20, 120) umfassen, an der die erste Position (31, 131) anzuordnen ist, wobei das Verfahren außerdem den Schritt umfasst:
Bewegen der Probe (20, 120), oder zumindest einer beabsichtigten Bahn des fokussierten Ionenstrahls (30, 130), um die erste Position (31, 131) entsprechend der Position auf der Probe (20, 120) örtlich festzulegen, vorzugsweise bevor das System zur Exposition mit dem fokussierten Ionenstrahl zur Mikrobearbeitung der Probe (20, 120) aktiviert wird,
wobei vorzugsweise der weitere Schritt umfasst ist:
Überwachen der örtlichen Festlegung der ersten Position (31, 20 131) auf der Probe (20, 120) , und/oder Überwachen der Mikrobearbeitung der Probe (20, 120) mit Hilfe des optischen Lichtmikroskops.

4. Verfahren nach einem der Ansprüche 1 - 3, wobei die Einstellungen eine Spotgröße des fokussierten Ionenstrahls (30, 130) an der ersten Position (31, 131) und/oder einen Strahlstrom des fokussierten Ionenstrahls (30, 130) umfassen.

5. Verfahren nach einem der Ansprüche 1 - 4, wobei das optische Lichtmikroskop ein hochauflösendes Mikroskopsystem umfasst, einschließlich solcher Typen, die eine strukturierte Beleuchtung verwenden, wobei das hochauflösende Mikroskopsystem Positionsinformationen von mindestens einem Teil des Bereichs von Interesse (21, 41, 51) mit einer Auflösung von etwa 300 nm oder weniger bereitstellt.

6. Verfahren nach einem der Ansprüche 1 - 5, wobei das Verfahren außerdem den folgenden Schritt umfasst:
Bereitstellen von Strukturen mit ersten fluoreszierenden Markierungen (46) um den Bereich von Interesse (21, 41, 51) herum, die durch das optische Lichtmikroskop betrachtet werden können,
wobei das Verfahren vorzugsweise außerdem den folgenden Schritt umfasst:
Überwachen der Mikrobearbeitung durch Beobachten des Fluoreszenzlichts der ersten fluoreszierenden Markierungen (46) unter Verwendung des optischen Lichtmikroskops.

7. Verfahren nach einem der Ansprüche 1 - 6, wobei das Verfahren außerdem den Schritt umfasst:
Versehen der Region von Interesse (21, 41, 51) mit zweiten fluoreszierenden Markierungen (56), die durch das optische Lichtmikroskop betrachtet werden können,
wobei das Verfahren vorzugsweise außerdem den folgenden Schritt umfasst:
Überwachen der Mikrobearbeitung durch Beobachten des Fluoreszenzlichts der zweiten Fluoreszenzmarken (56) unter Verwendung des optischen Lichtmikroskops.

8. Verfahren nach einem der Ansprüche 1 - 7, wobei das Verfahren außerdem den folgenden Schritt umfasst:
Herstellen einer oder mehrerer Lamellen (22, 42, 52) aus der Probe (20, 120), die mindestens einen Teil des Bereichs von Interesse (21, 41, 51) einschließt, wobei diese Lamelle (22, 42, 52) ein dünner Ausschnitt für eine dickere Probe ist, vorzugsweise mit einer Dicke, die zum Untersuchen der Lamelle (22, 42, 52) in einem TEM geeignet ist,
wobei die herzustellende Lamelle (22, 42, 52) vorzugsweise so ausgestaltet ist, dass sie eine Betrachtungsoberfläche (25, 25') umfasst, wobei das Verfahren den Schritt umfasst:
Ausrichten der Probe (20, 120) und des fokussierten Ionenstrahls so in Bezug zueinander, dass der fokussierte Ionenstrahl in einem schrägen oder streifenden Winkel in Bezug auf die Betrachtungsfläche (25, 25') auf die Probe (20, 120) trifft.

9. Verfahren nach Anspruch 8, wobei das Verfahren außerdem den Schritt umfasst:
Überwachen der Ausbildung der Lamelle (22, 42, 52) unter Verwendung des optischen Lichtmikroskops,
wobei der Überwachungsschritt vorzugsweise außerdem eines oder mehrere der Folgenden umfasst:
Bestimmen wie nah die Lamelle (22, 42, 52) daran ist, zumindest einen Teil des Bereichs von Interesse (21, 41, 51) zu enthalten,
Bestimmen eines Annäherungswinkels zwischen dem fokussierten Ionenstrahl (30, 130) und dem Bereich von Interesse (21, 41, 51),
Bestimmen, ob zumindest ein Teil des Bereichs von Interesse (21, 41, 51) noch innerhalb der Lamelle (22, 42, 52) eingeschlossen ist,
Bestimmen und/oder Korrigieren einer Drift der Position der Probe (20, 120), insbesondere zumindest einer Drift in einer Richtung parallel zu einer optischen Achse (OA) einer Objektivlinse (4, 104) des optischen Lichtmikroskops.

10. Verfahren nach Anspruch 8 oder 9, wobei das Verfahren außerdem den Schritt umfasst:
Auswerten der Lamellen (22, 42, 52) in einem TEM,
und
Verwenden eines Ergebnisses dieser Auswertung, um der Vorrichtung zur Mikrobearbeitung einer Probe (20, 25, 120) eine Rückmeldung zu geben, um die Ausrichtung eines Bereichs von Interesse (21, 41, 51) bei einer nachfolgenden Mikrobearbeitung einer Lamelle (22, 42, 52) zu verbessern.

11. Verfahren nach einem der Ansprüche 1 - 10, wobei der Probenhalter (2, 102) ein Kühlsystem zum Kühlen der Probe (20, 120) umfasst, wobei das Verfahren außerdem den Schritt umfasst:
Kühlen der Probe (20, 120) vor der Mikrobearbeitung der Probe mit dem fokussierten Ionenstrahl (30, 130), vorzugsweise Herunterkühlen der Probe (20, 120) auf eine kryogene Temperatur.

12. Eine Vorrichtung (1, 101) zur Mikrobearbeitung von Proben (20, 120), wobei die Vorrichtung (1, 101) eine integrale Kombination aus Folgendem umfasst:
einem Probenhalter (2, 102) zum Halten einer Probe (20, 120),
einem System zur Exposition mit einem fokussierten Ionenstrahl, das eine Anordnung zum Projizieren eines fokussierten Ionenstrahls (30, 130) auf eine erste Position (31, 131) umfasst, in der der fokussierte Ionenstrahl (30, 130) bei der Anwendung auf die Probe (20, 120), die von dem Probenhalter (2, 102) gehalten wird, auftrifft,
einem optischen Lichtmikroskop, wobei das optische Lichtmikroskop zum Darstellen oder Überwachen der ersten Position (31, 131) ausgestaltet ist,
wobei die Vorrichtung (1, 101) außerdem eine Steuerung umfasst, die so konfiguriert ist, dass die Vorrichtung bei Benutzung die Schritte des Verfahrens nach einem der Ansprüche 1 bis 11 ausführt.

13. Vorrichtung nach Anspruch 12, wobei das optische Lichtmikroskop umfasst:
eine Zylinderlinse (101, 102) und/oder
eine optische Objektivlinse (4) mit einer optischen Achse (OA), wobei die Vorrichtung (1, 101) einen Spiegel (22) umfasst, der auf der optischen Achse (OA) an einer von der optischen Objektivlinse (4) beabstandeten Position angeordnet ist, und wobei der Probenhalter (2, 102) zum Halten einer Probe (20, 120) zwischen der optischen Objektivlinse (4) und dem Spiegel (22) ausgestaltet ist, und/oder
einen Fokus-Tracker (115), wobei der Fokus-Tracker (115) vorzugsweise so konfiguriert ist, dass er das optische Lichtmikroskop auf die Probe (20, 120) und/oder auf eine Lamelle (22, 42, 52), die durch Mikrobearbeitung der Probe (20, 120) mit dem System zur Exposition gegenüber einem fokussierten Ionenstrahl erzeugt wird, ausrichtet.

14. Vorrichtung nach Anspruch 12 oder 13, wobei der Probenhalter (2, 102) ein Kühlsystem zum Kühlen der Probe (20, 120) umfasst, wobei vorzugsweise das Kühlsystem zum Herunterkühlen der Probe (20, 120) auf eine kryogene Temperatur ausgelegt ist.

15. Vorrichtung nach einem der Ansprüche 12 bis 14, wobei die Vorrichtung (1, 101) außerdem umfasst:
ein System zum Exponieren mit einem Elektronenstrahl, das eine Anordnung zum Projizieren eines Elektronenstrahls auf eine Position auf dem Probenhalter (2, 102), in der bei Gebrauch die Probe (20, 120) von dem Probenhalter (2, 102) gehalten wird, umfasst, und
ein Detektorsystem,
wobei der Probenhalter (2, 102) so ausgestaltet ist, dass er die Probe (20, 120) zwischen dem System zum Exponieren mit einem Elektronenstrahl und dem Detektorsystem positioniert, wobei das Detektorsystem so ausgestaltet ist, dass es Elektronen detektiert, die durch wenigstens einen Teil der Probe (20, 120), vorzugsweise durch eine Lamelle (22, 42, 52), hindurchtreten,
wobei das Detektorsystem vorzugsweise eine Platte aus einem Szintillatormaterial enthält, wobei die Platte aus Szintillatormaterial zwischen einer Position auf dem Probenhalter (2, 102), in der sich im Gebrauch eine Probe (20, 120) befindet, und einer Objektivlinse (4, 104) des optischen Lichtmikroskops angeordnet ist, wobei das optische Lichtmikroskop dafür ausgelegt ist, ein Bild von mindestens einem Teil der Platte des Szintillatormaterials zu erfassen,
wobei vorzugsweise die Vorrichtung (1, 101) ein Bedienteil zum Bewegen der Platte das Szintillatormaterials aus einer ersten Position (31, 131), in der das Szintillatormaterial zwischen der Position auf dem Probenhalter (2, 102), in der sich im Gebrauch eine Probe (20, 120) befindet, und der Objektivlinse (4, 104) des Lichtmikroskops angeordnet ist, zu einer zweiten Position, in der das Szintillatormaterial aus dem Bereich zwischen der Position auf dem Probenhalter (2, 102), an der sich im Gebrauch eine Probe (20, 120) befindet, und der Objektivlinse (4, 104) des Lichtmikroskops entfernt wird oder umgekehrt, umfasst.

## Revendications

1. Procédé de micro-usinage d'un échantillon à l'aide d'un appareil (1, 101) destiné au micro-usinage d'échantillons (20, 120), dans lequel l'appareil (1, 101) comprend une combinaison intégrale de :
un porte-échantillon (2, 102) destiné à maintenir l'échantillon (20, 120),
un système d'exposition de faisceau d'ions concentré comprenant un ensemble destiné à projeter un faisceau d'ions concentré (30, 130) vers un premier emplacement (31, 131) auquel, pendant l'utilisation, le faisceau d'ions concentré (30, 130) heurte l'échantillon (20, 120) maintenu par le porte-échantillon (2, 102), et
un microscope optique, dans lequel le microscope optique est configuré pour imager ou surveiller l'échantillon (20, 120) sur le porte-échantillon (2, 102),
dans lequel le procédé comprend l'étape :
de capture d'une ou plusieurs image(s) de microscopie optique de l'échantillon (20, 120) maintenu par le porte-échantillon (2, 102) et est **caractérisé par** les étapes supplémentaires :
de détermination d'une position et des dimensions physiques d'une zone d'intérêt (21, 41, 51) dans l'échantillon (20, 120) sur la base de la ou des image(s) de microscopie optique ;
d'établissement, à partir de la ou des image(s) de microscopie optique, de paramètres du porte-échantillon (2, 102) et/ou du système d'exposition de faisceau d'ions concentré pour le micro-usinage de l'échantillon (20, 120) afin de réduire une distance entre au moins une partie de la zone d'intérêt (21, 41, 51) et la surface de l'échantillon (20, 120) ou de produire une lamelle (22, 42, 52) qui intègre au moins une partie de la zone d'intérêt (21, 41, 51) ; et
d'activation du système d'exposition de faisceau d'ions concentré selon les paramètres pour le micro-usinage de l'échantillon (20, 120).

2. Procédé selon la revendication 1, comprenant en outre l'étape :
d'établissement, à partir de la ou des image(s) de microscopie optique, de la ou des parties de l'échantillon (20, 120) qui doit/doivent être micro-usinée(s) par le système d'exposition de faisceau d'ions concentré afin de réduire la distance entre au moins une partie de la zone d'intérêt (21, 41, 51) et la surface de l'échantillon (20, 120) ou de produire une lamelle (22, 42, 52) qui intègre au moins une partie de la zone d'intérêt (21, 41, 52).

3. Procédé selon la revendication 1 ou 2, dans lequel les paramètres comprennent un emplacement sur l'échantillon (20, 120) auquel placer le premier emplacement, dans lequel le procédé comprend en outre l'étape :
de déplacement de l'échantillon (20, 120) ou d'au moins une trajectoire prévue du faisceau d'ions concentré (30, 130) afin de situer le premier emplacement (31, 131) à l'emplacement sur l'échantillon (20, 120) en conséquence, de préférence avant d'activer le système d'exposition de faisceau d'ions concentré pour le micro-usinage de l'échantillon (20, 120),
comprenant de préférence en outre l'étape :
de surveillance de la localisation du premier emplacement (31, 131) sur l'échantillon (20, 120) et/ou de surveillance du micro-usinage de l'échantillon (20, 120) à l'aide du microscope optique.

4. Procédé selon l'une quelconque des revendications 1 à 3, dans lequel les paramètres comprennent un diamètre de faisceau du faisceau d'ions concentré (30, 130) au premier emplacement (31, 131) et/ou un courant de faisceau du faisceau d'ions concentré (30, 130).

5. Procédé selon l'une quelconque des revendications 1 à 4, dans lequel le microscope optique comprend un système de microscopie à super-résolution, comprenant des types qui utilisent un éclairage structuré, dans lequel le système de microscopie à super-résolution fournit des informations de position d'au moins une partie de la zone d'intérêt (21, 41, 51) avec une résolution d'environ 300 nm ou moins.

6. Procédé selon l'une quelconque des revendications 1 à 5, dans lequel le procédé comprend en outre l'étape :
de mise en place de structures autour de la zone d'intérêt (21, 41, 51) avec des premières étiquettes fluorescentes (46) qui peuvent être observées par le microscope optique,
dans lequel, de préférence, le procédé comprend en outre l'étape :
de surveillance du micro-usinage en observant la lumière fluorescente produite par lesdites premières étiquettes fluorescentes (46) à l'aide du microscope optique.

7. Procédé selon l'une quelconque des revendications 1 à 6, dans lequel le procédé comprend en outre l'étape :
de mise en place, dans la zone d'intérêt (21, 41, 51), de deuxièmes étiquettes fluorescentes (56) qui peuvent être observées par le microscope optique,
dans lequel, de préférence, le procédé comprend en outre l'étape :
de surveillance du micro-usinage en observant la lumière fluorescente produite par lesdites deuxièmes étiquettes fluorescentes (56) à l'aide du microscope optique.

8. Procédé selon l'une quelconque des revendications 1 à 7, dans lequel le procédé comprend en outre l'étape :
de fabrication d'une ou plusieurs lamelle(s) (22, 42, 52) à partir de l'échantillon (20, 120) qui comprend au moins une partie de la zone d'intérêt (21, 41, 51), dans lequel ladite lamelle (22, 42, 52) est une fine découpe pour un échantillon plus épais, de préférence avec une épaisseur adaptée pour étudier la lamelle (22, 42, 52) avec un microscope électronique à transmission,
dans lequel, de préférence, la lamelle produite (22, 42, 52) est configurée pour comprendre une surface d'observation (25, 25'), le procédé comprenant l'étape :
d'orientation de l'échantillon (20, 120) et du faisceau d'ions concentré l'un par rapport à l'autre de sorte que le faisceau d'ions concentré heurte l'échantillon (20, 120) à un angle oblique ou rasant par rapport à ladite surface d'observation (25, 25').

9. Procédé selon la revendication 8, dans lequel le procédé comprend en outre l'étape :
de surveillance de la création de la lamelle (22, 42, 52) à l'aide du microscope optique,
dans lequel, de préférence, l'étape de surveillance comprend en outre une ou plusieurs de ce qui suit :
la détermination de la mesure dans laquelle la lamelle (22, 42, 52) contient au moins une partie de la zone d'intérêt (21, 41, 51),
la détermination d'un angle d'approche entre le faisceau d'ions concentré (30, 130) et la zone d'intérêt (21, 41, 51),
la détermination du fait qu'au moins une partie de la zone d'intérêt (21, 41, 51) soit toujours contenue dans la lamelle (22, 42, 52),
la détermination et/ou la correction d'une dérive de la position de l'échantillon (20, 120), en particulier au moins d'une dérive dans une direction parallèle à un axe optique (OA) d'une lentille d'objectif (4, 104) du microscope optique.

10. Procédé selon la revendication 8 ou 9, dans lequel le procédé comprend en outre l'étape :
d'évaluation de la lamelle (22, 42, 52) avec un microscope électronique à transmission, et
d'utilisation d'un résultat de ladite évaluation pour fournir un retour à l'appareil destiné au micro-usinage d'un échantillon (20, 120) afin d'améliorer le ciblage d'une zone d'intérêt (21, 41, 51) lors d'un micro-usinage ultérieur d'une lamelle (22, 42, 52).

11. Procédé selon l'une quelconque des revendications 1 à 10, dans lequel le porte-échantillon (2, 102) comprend un système de refroidissement destiné à refroidir l'échantillon (20, 120), dans lequel le procédé comprend en outre l'étape :
de refroidissement de l'échantillon (20, 120) avant le micro-usinage de l'échantillon par le faisceau d'ions concentré (30, 130), de préférence de refroidissement de l'échantillon (20, 120) jusqu'à une température cryogénique.

12. Appareil (1, 101) destiné au micro-usinage d'échantillons (20, 120), dans lequel l'appareil (1, 101) comprend une combinaison intégrale de :
un porte-échantillon (2, 102) destiné à maintenir un échantillon (20, 120),
un système d'exposition de faisceau d'ions concentré comprenant un ensemble destiné à projeter un faisceau d'ions concentré (30, 130) vers un premier emplacement (31, 131) auquel, pendant l'utilisation, le faisceau d'ions concentré (30, 130) heurte l'échantillon (20, 120) maintenu par le porte-échantillon (2, 102), et
un microscope optique, dans lequel le microscope optique est configuré pour imager ou surveiller ledit premier emplacement (31, 131), dans lequel l'appareil (1, 101) comprend en outre un dispositif de commande qui est configuré pour commander l'appareil afin qu'il exécute, pendant l'utilisation, les étapes du procédé selon l'une quelconque des revendications 1 à 11.

13. Appareil selon la revendication 12, dans lequel le microscope optique comprend :
une lentille cylindrique (101, 102), et/ou
une lentille d'objectif optique (4) ayant un axe optique (OA), dans lequel l'appareil (1, 101) comprend un miroir (22) qui est prévu sur l'axe optique (OA) à un emplacement espacé de la lentille d'objectif optique (4), et dans lequel le porte-échantillon (2, 102) est configuré pour maintenir un échantillon (20, 120) entre la lentille d'objectif optique (4) et le miroir (22), et/ou
un système de suivi automatique de mise au point (115), dans lequel, de préférence, le système de suivi automatique de mise au point (115) est configuré pour focaliser le microscope optique sur l'échantillon (20, 120) et/ou sur une lamelle (22, 42, 52) qui est créé en micro-usinant l'échantillon (20, 120) à l'aide du système d'exposition de faisceau d'ions concentré.

14. Appareil selon la revendication 12 ou 13, dans lequel le porte-échantillon (2, 102) comprend un système de refroidissement destiné à refroidir l'échantillon (20, 120), dans lequel, de préférence, le système de refroidissement est configuré pour refroidir l'échantillon (20, 120) jusqu'à une température cryogénique.

15. Appareil selon l'une quelconque des revendication 12 à 14, dans lequel l'appareil (1, 101) comprend en outre :
un système d'exposition de faisceau d'électrons comprenant un ensemble destiné à projeter un faisceau d'électrons vers un emplacement sur le porte-échantillon (2, 102) auquel, pendant l'utilisation, le faisceau d'électrons heurte l'échantillon (20, 120) maintenu par le porte-échantillon (2, 102), et
un système de détection,
dans lequel le porte-échantillon (2, 102) est configuré pour positionner l'échantillon (20, 120) entre le système d'exposition de faisceau d'électrons et le système de détection, dans lequel le système de détection est configuré pour détecter les électrons transmis à travers au moins une partie de l'échantillon (20, 120), de préférence à travers une lamelle (22, 42, 52),
dans lequel, de préférence, le système de détection comprend une feuille de matériau scintillateur, dans lequel la feuille de matériau scintillateur est prévue entre un emplacement sur le porte-échantillon (2, 102) auquel, pendant l'utilisation, un échantillon (20, 120) est positionné, et une lentille d'objectif (4, 104) du microscope optique, dans lequel le microscope optique est configuré pour acquérir une image d'au moins une partie de la feuille de matériau scintillateur,
dans lequel, de préférence, l'appareil (1, 101) comprend un actionneur destiné à déplacer la feuille de matériau scintillateur d'un premier emplacement (31, 131) auquel le matériau scintillateur est prévu entre l'emplacement sur le porte-échantillon (2, 102) auquel, pendant l'utilisation, un échantillon (20, 120) est positionné, et la lentille d'objectif (4, 104) du microscope optique, vers un deuxième emplacement auquel le matériau scintillateur est retiré de la zone située entre l'emplacement sur le porte-échantillon (2, 102) auquel, pendant l'utilisation, un échantillon (20, 120) est positionné, et la lentille d'objectif (4, 104) du microscope optique, ou inversement.
